# EUROPEAN PATENT SPECIFICATION

(11) **EP 1 244 177 B1**
(45) Date of publication and mention of the grant of the patent: **09.06.2004**
(21) Application number: 02076231.6
(22) Date of filing: 19.03.2002
(51) Int. Cl.: H01R 12/08

(54) **Electrical device and method for connecting a cable to the same**
Elektrische Vorrichtung und Verfahren um daran ein Kabel zu befestigen
Dispositif électrique et procédé pour la connexion d'un câble à celui-ci

(30) Priority: 20.03.2001 NL 1017643
(43) Date of publication of application: 25.09.2002
(73) Proprietor: FCI, 75009 Paris (FR)
(72) Inventor: Droesbeke, Gert, 2440 Geel (BE)
(74) Representative: Aalbers, Arnt Reinier

(56) References cited:
- DE-A- 19 630 424
- DE-A- 19 719 449
- DE-B- 1 061 862

## Description

The invention pertains to an electrical device, such as a connector module, comprising a housing having a substrate, e.g. a printed circuit board, provided with contact elements, and a cable comprising an outer jacket surrounding a plurality of wires at least two of which extend from an end of the jacket and are connected to a corresponding number of the contact elements, the said end of the jacket being attached to the housing in a position fixed relative to the substrate.

The invention also pertains to a method according to the preamble of claim 8.

A device such as that described in the opening paragraph is known from, e.g., International Patent Application WO 99/19213-A2, which is considered as the closest prior art. This document describes an assembly for splicing multiple screened cables. In the embodiment shown, the pre-stripped ends of the cables are soldered onto tracks on the stripline board (the substrate).

WO 99/19213-A2 also discloses a way of deflecting the force from the connections between wire cores and contact elements on the substrate. The embodiments described therein comprise a crimp ferrule for each wire. The ferrule tightly connects to the mantle of a wire and is held in place in an insulating block.

As such, the solution of the prior art uses a multitude of parts to provide strain relief to the connections of the wires. Similar solutions known from the prior art also occupy a relatively large amount of space on the surface of the substrate; as a result of using both ferrules and a block, the wire cores are spread further apart. Such solutions also require stripping off a comparatively long part of the outer jacket to expose the necessary extending portions of wire when splicing the cable.

It is an object of the present invention to improve the devices described in the opening paragraphs.

To this end, the device according to the invention is characterised in that the extending portion of at least one of the wires is substantially free to move relative to the substrate.

A preferred embodiment of a device according to the present invention, comprising a housing having a substrate provided with contact elements for connection to the wires, at least one of the contact elements being substantially free to move relative to the other elements and the substrate.

In another preferred embodiment, the portions of the wires which extend from an end of the jacket flex and/or shift upon bending the cable in a plane through or parallel to the substrate.

In these embodiments, tugging forces exerted on the wire lead are absorbed by the flexing and friction of the moving wire, rather than by deformation of the contacts between wire and substrate. Thus substantial strain relief is provided to the connections between wire core and contact element, when the cable as a whole is bent, through relatively simple and compact means.

The method according to the present invention is characterised in that at least one of the wires is left substantially free to move relative to the substrate. This method of connection yields a device with the same advantages as the device according to the present invention.

The invention will now be explained in more detail with reference to the drawings.

Fig. 1 shows schematically the directions in which the wires of a twin-axial cable are forced upon its being bent.

Fig. 2 shows a perspective view of a device comprising two twin-axial cables connected to the substrate in a device according to an embodiment of the present invention.

Fig. 3 shows a side-view of the same embodiment, demonstrating how it leaves a wire substantially free to move with respect to the substrate.

Fig. 4 shows a top view of a cross-section of a device, according to another embodiment of the invention, wherein the parts of the wire extending from an end of the jacket are bent.

Fig. 5 shows three consecutive steps in a method according to the present invention.

Multi-axial cables are often used to convey multiple signals to devices having substrates. An example of such a device is a computer. Another example is a connector module, suitable for use in a wide range of further devices or for stringing together, to assemble a larger, or more complex connector. One strives to make such a connector module as small as possible, preferably with dimensions in a range between 1 and 5 mm, in order to use it in as many other devices as possible.

The conducting cores in the wires are typically attached to contact elements on a printed circuit board. Due to the plurality of closely packed wires and the need to preserve space on the substrate, such attachments are preferably quite simple.

Often, the wire cores are directly soldered onto leads on the substrate. Alternatively, the contact element could comprise some sort of clamping mechanism, relying on friction to maintain the connection. In general, the connection is not capable of withstanding any large straining forces in a direction along the axis of the wire.

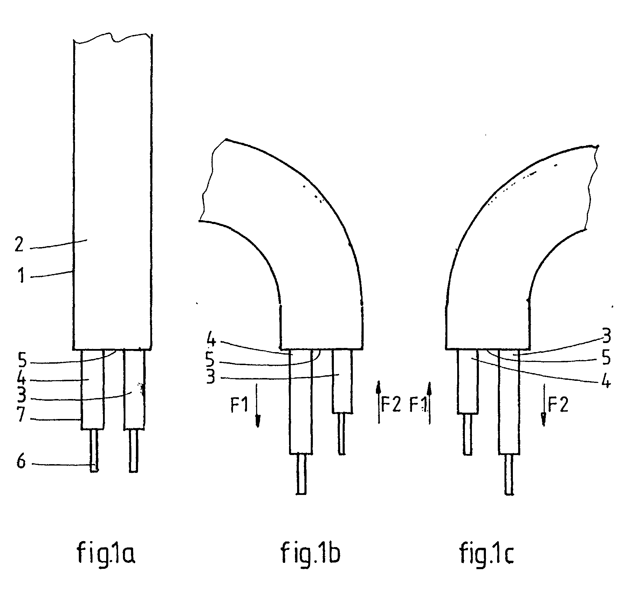

Referring now to figure 1, an aspect of the problem of strain on the connection between wire and contact element will be explained more fully. The figure shows a schematic drawing of an end part of a cable 1, such as may be comprised in an embodiment of a device according to the present invention.

It comprises an outer jacket 2, surrounding a plurality of wires 3,4, at least two of which extend from an end 5 of the jacket 2. The jacket 2 could comprise multiple layers. The outermost layer serves to protect the cable 1 and insulate it from the environment. It will generally be made of plastic or a composite material. An optional inner layer could be made conducting, to shield the cable 1 from interference. Alternative optional inner layers could be used to provide extra stiffness or strength to the jacket 2. Part of the jacket 4 has been stripped away, leaving a portion of the wires 3,4 extending from the end 5 of the jacket 2.

The wires 3,4 comprise a conductive core 6 and a surrounding jacket 7. The primary purpose of the jacket 7 is to prevent interference between the wires 3,4. It insulates the wire 3 from the other wire(s) 4. Optionally, it can also comprise multiple layers, e.g. including a conductive shielding to prevent cross-talk between the wires 3,4. Generally, the outer surface of the wire jacket 7 will again be made of plastic or a composite. A side effect of such materials is the low amount of mutual friction between the wires 3,4, and between the wires 3,4, and the outer jacket 5. Figure 1 shows the cable in a stage prior to assembly with another device. The jackets 7 of the wires 3,4 have been partially stripped, to leave an end of the conducting cores 6 exposed. These ends can then be attached to contact elements, which are not shown.

Figure 1b shows what happens when the cable 1, of which the other end is rigidly attached to some device, is bent to the left. As the part of the jacket on the inner, leftmost side of the cable 1 is compressed, the length along the jacket 2 on this side decreases, so pushing the leftmost wire 4 out of the jacket 2, leaving a larger part of it extending from the end 5. By bending the cable 1, the outer curved part of the jacket 2 is stretched, thus lengthening it. In the process, some of the extending part of the rightmost wire 3 retracts into the jacket in the direction of the pulling force F₂ exerted on it.

Figure 1c shows the opposite situation, where the cable is bent to the right. In this case, movement of the wires 3,4 is in the opposite respective direction F₁, F₂.

In the situation shown in figure 1, the parts of the wires 3,4 extending from the outer end 5 of the jacket 2 are not connected. Thus, they are substantially free to move within the jacket 2. Were these extending parts of the wires 3,4 to be connected and held in a fixed position relative to the other extending parts, or the jacket 2, the forces F₁ and F₂ would be counteracted by oppositely directed forces exerted on the wires 3,4 by whichever means is holding them in position. Physically, such a force is created by elastic deformation of the connecting means and the wire 3,4. If these means comprise a soldered connection to a substrate, the joint will be strained.

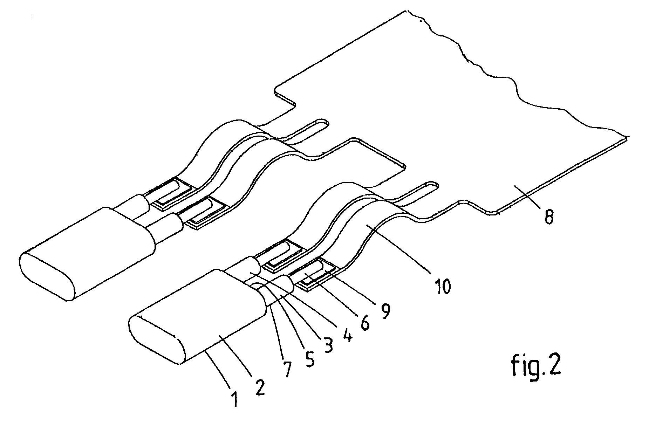

Figure 2 shows a perspective view of part of an embodiment of a device according to the present invention. The housing is left out to provide a better view of a substrate 8, contained therein. In this embodiment, the substrate is a circuit board. Electrical leads (not shown) could additionally be located on, or embedded in, the circuit board 8.

The embodiment shown comprises two twin-axial cables 1. The wires 3,4 of which a cable comprises are soldered to contact elements 9. In the embodiment shown, the attachment is created by soldering. Alternatively, the wires 3,4 could be glued on the contact elements, for example with resin, clamped on with screws, etc.

The embodiment of an electrical device as shown in Figure 2 permits substantial freedom of movement to the contact elements 9. This is done by means of flexible extensions 10 to the substrate.

In this particular case, the flexible extensions 10 are made from the same material as the substrate 8 and form an integral part with it. As an alternative, the flexible extensions 10 could be made of a different material. This could be necessary if the substrate 8 is to be made stiffer.

It is not a necessary aspect of the present invention that all contact elements 9 be substantially free to move. E.g., one of each pair of contact elements 9, connected to the two wires 3,4 of a twin-axial cable, would suffice to provide the desired strain relief.

Likewise, the substantial freedom of movement could be otherwise provided, e.g. by a sliding or rotating contact element, as long as conductive contact of the wire 3,4 to the associated lead on the substrate 8 is maintained.

The wires 3,4 are substantially free to move in both directions. This means that the part of the wire 3,4, extending from the end 5 of the outer jacket 2 can vary in length. Whether it increases or decreases in length depends on the direction in which the cable 1 is bent and on the position of the wire concerned relative to the other wires 3,4.

The substantial freedom of movement in both directions is afforded by the use of flexible extensions 10 that are pre-bent. The bend can be laid during assembly of the device comprising the substrate. In this case, the extensions 10 would be tensioned. Alternatively, the extensions 10 can be thus manufactured. As an example, they could be made from a laminated or fibre composite material with selectively crimped surface layers.

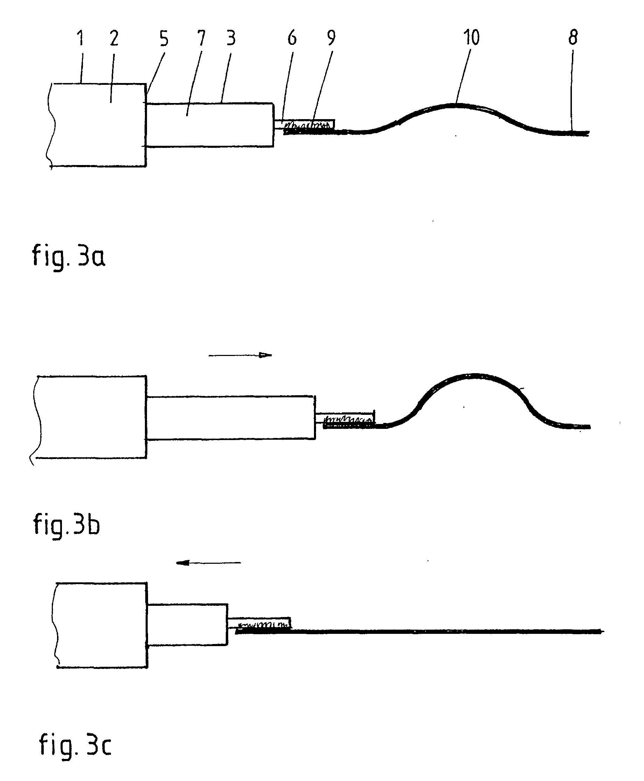

Figure 3 depicts a side view of the embodiment of figure 2. The figure clearly demonstrates how the pre-bent flexible extensions 10 allow the portion of the wire 3,4 extending from the end 5 of the outer jacket 2 substantial freedom to move in both directions. A pushing force on the wire 3,4, as in figure 3b, will cause the extension 10 to bend further. A pulling force on the wire 3,4 will cause the extension 10 to straighten out.

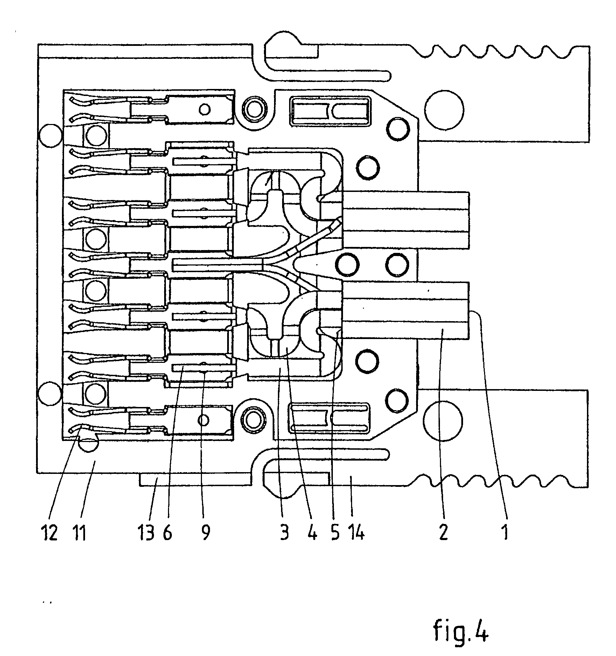

The same strain relief is provided by an alternative embodiment, as shown in figure 4. Here, no flexible extensions 10 are necessary, although they could optionally be included. Instead, the portion of wire 3,4 extending from the end 5 of the outer jacket 2 of the cable 1 is pre-bent during assembly to allow the wire 3,4 substantial freedom of movement. In the embodiment shown, the wires 3,4 are bent to form a loop in the plane of the substrate. In another embodiment, the loop in the wire can be laid in a direction normal to the substrate 8, to prevent adjacent wires 3,4 from interfering with each other.

In this embodiment, the lower inside face of the housing comprises the substrate 8. This connector module is intended for attachment to another connector. Accordingly, the substrate 8 merely supports the contact element 9. The contact element has a specially shaped clamping section 12 at the rear, provided for making contact with the other connector. The embodiment of figure 4 further comprises an insulating shielding 13, carrying latches 14, for establishing secure mechanical contact with the other connector.

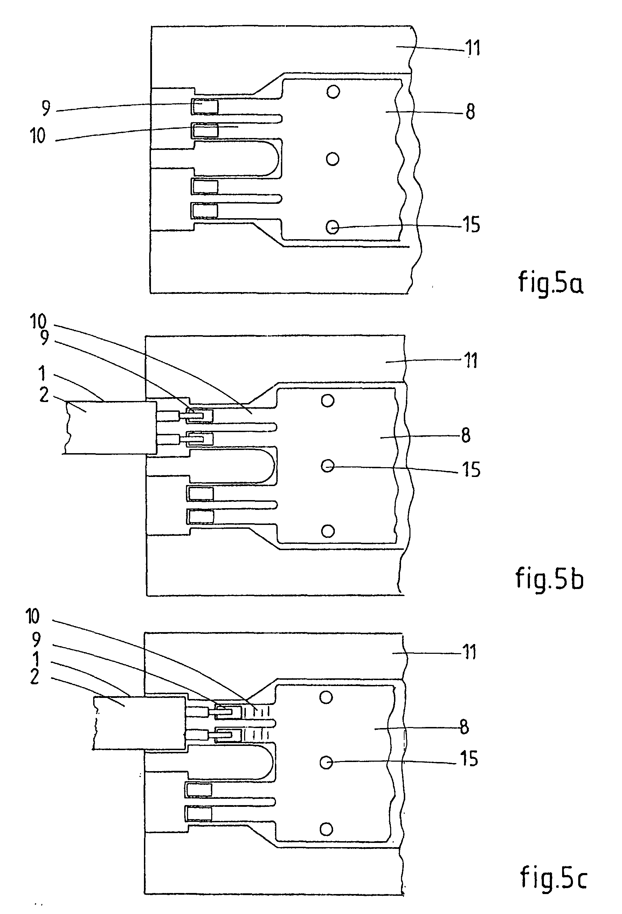

Figure 5 shows an embodiment of a method according to the present invention, and a cross-section of an embodiment of a device according to the invention, before connection to the cable 1. The device comprises the same flexible extensions 10 as the embodiment of figures 2 and 3. Figure 5 also shows that the device comprises a housing 11.

In the depicted embodiment of the method of connection, the cable 1 is first inserted into the housing 11 and the cores 6 of the wires 3,4 are connected to the contact elements 10. In this case, these are provided on the extensions 10. The situation as shown in Figure 5b is hereby created. In subsequent stages, the cable 1 is further inserted into the housing 11, so causing the pre-bending of the flexible extensions 10. After this, the end 5 of the outer jacket is fixed in position relative to the substrate 8. In the example shown, these means comprise the housing, to which the substrate is attached with plastic rivets 15. Any other means, e.g. glue, snap locks or plugs, would also serve the purpose. The attachment of the outer jacket 2 to the housing 11 is not shown in Figure 5. The outer jacket 2 could be glued, clamped or otherwise attached. In addition, it is not a necessary aspect of the invention that the means for holding the end 5 fixed in position relative to the substrate 8 comprise only the housing. A separate body or framework within the housing is also a possibility.

The invention is not restricted to the above described embodiments which can be varied in a number of ways within the scope of the claims. For example, the substrate need not necessarily be a printed circuit board. It can be a composite foil with embedded wires, or it could be a metal part. It is not essential that the substrate comprise any logic circuitry. It could merely transmit signals to another connector module connected that of the present invention.

## Claims

1. Electrical device, such as a connector module, comprising a housing (11) having a substrate (8), e.g. a printed circuit board, provided with contact elements (9), and a cable (1) comprising an outer jacket (2) surrounding a plurality of wires (3,4) at least two of which extend from an end (5) of the jacket (2) and are connected to a corresponding number of the contact elements (9), the said end (5) of the jacket (2) being attached to the housing (11) in a position fixed relative to the substrate (8),
**characterised in that** the extending portion of at least one of the wires (3,4) is substantially free to move relative to the substrate (8).

2. Device according to claim 1, wherein the said portion flexes and/or shifts upon bending the cable (1) in a plane through or parallel to the substrate (8).

3. Device according to claim 1 or 2, wherein the length of the said portion is greater than the distance between the end of the jacket (5) and the contact element (9) to which the wire (3,4) is attached.

4. Device according to claim 1, wherein the substrate is provided with contact elements (9) for connection to the said wires (3, 4), at least one of said contact elements being substantially free to move relative to the other elements (9) and the substrate (8).

5. Device according to claim 4, wherein the movable element (9) is located on a flexible extension (10) of the substrate (8).

6. Device according to claim 5, wherein the extension (10) is of the same material as the board (8) and forms an integral whole with the board (8).

7. Device according to claims 5 or 6, wherein the extensions (10) are pre-bent.

8. Method for connecting a cable (1), comprising an outer jacket (2) surrounding a plurality of wires (3,4) at least two of which extend from an end (5) of the jacket (2), to an electrical device, such as a connector module, comprising a housing (11), having a substrate (8) provided with contact elements (9) for connection to the said wires (3,4), wherein the method comprises at least the step of attaching the outer jacket (2) of the cable (1) to the housing (11) in a position fixed relative to the substrate (8) and wherein the method is further **characterised in that** at least one of the wires (3,4) is left substantially free to move relative to the substrate (8).

9. Method according to claim 8, wherein the wires (3,4) are connected to the contact elements (9) in such a way as to leave a distance between the end (5) of the outer jacket (2) of the cable (1) and the device, wherein the distance is subsequently closed by attaching the end (5) of the outer jacket (2) to the device in a position fixed relative to the substrate (8).

10. Method according to claim 8 or 9, wherein in performing the step of closing the distance between the end (5) of the outer jacket (2) and the device, the parts of the wires (3,4) extending from an end (5) of the jacket (2) are bent.

11. Method according to claim 8 or 9, wherein the substrate (8) further comprises flexible extensions (10), on which the contact elements (9) are located, wherein in performing the step of closing the distance between the end (5) of the outer jacket (2) and the device, a bend in the flexible extensions (10) is created.

12. Method according to any of claims 8-11, wherein the contact elements (9) are formed by soldering a wire (3,4) to a lead.

## Patentansprüche

1. Elektrische Vorrichtung, wie zum Beispiel ein Verbindermodul, die ein Gehäuse (11), das ein mit Kontaktelementen (9) versehenes Substrat (8), zum Beispiel eine Leiterplatte, enthält, und ein Kabel (1) aufweist, das einen äußeren Kabelmantel (2) besitzt, der mehrere Drähte (3, 4) umgibt, von denen mindestens zwei aus einem Ende (5) des Kabelmantels (2) vorstehen und mit einer entsprechenden Anzahl der Kontaktelemente (9) verbunden sind, wobei das Ende (5) des Kabelmantels (2) am Gehäuse (11) in einer in Bezug auf das Substrat (8) ortsfesten Stellung befestigt ist,
**dadurch gekennzeichnet, dass** der vorstehende Abschnitt mindestens eines der Drähte (3, 4) im wesentlichen frei ist, um sich in Bezug auf das Substrat (8) zu bewegen.

2. Vorrichtung nach Anspruch 1, wobei der Abschnitt sich beim Krümmen des Kabels (1) in einer durch das oder parallel zum Substrat (8) verlaufenden Ebene biegt und/oder verschiebt.

3. Vorrichtung nach Anspruch 1 oder 2, wobei die Länge des Abschnitts größer ist als der Abstand zwischen dem Ende (5) des Kabelmantels und dem Kontaktelement (9), an dem der Draht (3, 4) befestigt ist.

4. Vorrichtung nach Anspruch 1, wobei das Substrat mit Kontaktelementen (9) zur Verbindung mit den Drähten (3, 4) versehen ist, wobei mindestens eines der Kontaktelemente in Bezug auf die anderen Elemente (9) und das Substrat (8) im wesentlichen frei beweglich ist.

5. Vorrichtung nach Anspruch 4, wobei das bewegliche Element (9) auf einer elastischen Verlängerung (10) des Substrats (8) angeordnet ist.

6. Vorrichtung nach Anspruch 5, wobei die Verlängerung (10) aus dem gleichen Material ist wie die Leiterplatte (8) und aus einem Stück mit der Leiterplatte (8) besteht.

7. Vorrichtung nach Anspruch 5 oder 6, wobei die Verlängerungen (10) vorgekrümmt sind.

8. Verfahren zum Verbinden eines Kabels (1), das einen äußeren Kabelmantel (2) aufweist, der mehrere Drähte (3, 4) umgibt, von denen mindestens zwei von einem Ende (5) des Kabelmantels (2) vorstehen, mit einer elektrischen Vorrichtung, wie zum Beispiel einem Verbindermodul, die ein Gehäuse (11) aufweist, das ein Substrat (8) enthält, welches mit Kontaktelementen (9) zur Verbindung mit den Drähten (3, 4) versehen ist, wobei das Verfahren zumindest den Schritt der Befestigung des äußeren Kabelmantels (2) des Kabels (1) am Gehäuse (11) in einer in Bezug auf das Substrat (8) ortsfesten Stellung enthält, und wobei das Verfahren weiter **dadurch gekennzeichnet ist, dass** mindestens einer der Drähte (3, 4) in Bezug auf das Substrat (8) im wesentlichen frei beweglich bleibt.

9. Verfahren nach Anspruch 8, wobei die Drähte (3, 4) derart mit den Kontaktelementen (9) verbunden sind, dass ein Abstand zwischen dem Ende (5) des äußeren Kabelmantels (2) des Kabels (1) und der Vorrichtung gelassen wird, wobei der Abstand anschließend durch Befestigung des Endes (5) des äußeren Kabelmantels (2) an der Vorrichtung in einer in Bezug auf das Substrat (8) ortsfesten Stellung geschlossen wird.

10. Verfahren nach Anspruch 8 oder 9, wobei bei der Durchführung des Schritts des Schließens des Abstands zwischen dem Ende (5) des äußeren Kabelmantels (2) und der Vorrichtung die Teile der Drähte (3, 4), die aus einem Ende (5) des Kabelmantels (2) vorstehen, gekrümmt werden.

11. Verfahren nach Anspruch 8 oder 9, wobei das Substrat (8) weiter elastische Verlängerungen (10) aufweist, auf denen die Kontaktelemente (9) angeordnet sind, wobei bei der Durchführung des Schritts des Schließens des Abstands zwischen dem Ende (5) des äußeren Kabelmantels (2) und der Vorrichtung eine Krümmung der elastischen Verlängerungen (10) erzeugt wird.

12. Verfahren nach einem der Ansprüche 8 bis 11, wobei die Kontaktelemente (9) durch Löten eines Drahts (3, 4) auf einen Anschluss geformt werden.

## Revendications

1. Dispositif électrique, tel qu'un module de connecteur, comprenant un boîtier (11) présentant un substrat (8), par exemple une carte de circuit imprimé, doté d'éléments de contact (9), et un câble (1) comprenant une gaine extérieure (2) entourant une pluralité de fils électriques (3, 4), dont au moins deux s'étendent depuis une extrémité (5) de la gaine (2) et sont connectés à un nombre correspondant des éléments de contact (9), ladite extrémité (5) de la gaine (2) étant fixée au boîtier (11) dans une position fixe par rapport au substrat (8), **caractérisé en ce que** la partie d'extension d'au moins un des fils électriques (3, 4) est sensiblement libre de se déplacer par rapport au substrat (8).

2. Dispositif selon la revendication 1, dans lequel ladite partie se courbe et / ou se décale lors de la flexion du câble (1) dans un plan transversal au substrat (8) ou parallèle à celui-ci.

3. Dispositif selon l'une quelconque des revendications 1 ou 2, dans lequel la longueur de ladite partie est supérieure à la distance entre l'extrémité de la gaine (5) et l'élément de contact (9) auquel est fixé le fil électrique (3, 4).

4. Dispositif selon la revendication 1, dans lequel le substrat est doté d'éléments de contact (9) destinés à être connectés auxdits fils électriques (3, 4), au moins l'un desdits éléments de contact étant sensiblement libre de se déplacer par rapport aux autres éléments (9) et au substrat (8).

5. Dispositif selon la revendication 4, dans lequel l'élément mobile (9) est situé sur une extension flexible (10) du substrat (8).

6. Dispositif selon la revendication 5, dans lequel l'extension (10) est réalisée dans le même matériau que la carte (8) et forme un tout avec la carte (8).

7. Dispositif selon l'une quelconque des revendications 5 ou 6, dans lequel les extensions (10) sont courbées au préalable.

8. Procédé permettant de connecter un câble (1), comprenant une gaine extérieure (2) entourant une pluralité de fils électriques (3, 4) dont au moins deux s'étendent depuis une extrémité (5) de la gaine (2), à un dispositif électrique, tel qu'un module de connecteur, comprenant un boîtier (11) présentant un substrat (8) doté d'éléments de contact (9) destinés à être connectés auxdits fils électriques (3,4), dans lequel le procédé comprend au moins l'étape consistant à fixer la gaine extérieure (2) du câble (1) au boîtier (11) dans une position fixe par rapport au substrat (8), et dans lequel le procédé est en outre **caractérisé en ce qu'**au moins deux des fils électriques (3, 4) sont sensiblement libres de se déplacer par rapport au substrat (8).

9. Procédé selon la revendication 8, dans lequel les fils électriques (3, 4) sont connectés aux éléments de contact (9) de manière à laisser une certaine distance entre l'extrémité (5) de la gaine extérieure (2) du câble (1) et le dispositif, dans lequel la distance est sensiblement annulée en fixant l'extrémité (5) de la gaine extérieure (2) au dispositif dans une position fixe par rapport au substrat (8).

10. Procédé selon la revendication 8 ou 9, dans lequel, en réalisant l'étape consistant à annuler la distance entre l'extrémité (5) de la gaine extérieure (2) et le dispositif, les parties des fils électriques (3, 4) s'étendant depuis une extrémité (5) de la gaine (2) sont recourbées.

11. Procédé selon l'une quelconque des revendications 8 ou 9, dans lequel le substrat (8) comprend en outre des extensions flexibles (10), sur lesquelles sont situés les éléments de contact (9), dans lequel, en réalisant l'étape consistant à annuler la distance entre l'extrémité (5) de la gaine extérieure (2) et le dispositif, on crée une courbure dans les extensions flexibles (10).

12. Procédé selon l'une quelconque des revendications 8 à 11, dans lequel les éléments de contact (9) sont formés en soudant un fil électrique (3, 4) sur un conducteur.
